(19) Europäisches Patentamt
European Patent Office
Office européen des brevets

(11) **EP 4 195 185 A1**

(12) **EUROPEAN PATENT APPLICATION**
published in accordance with Art. 153(4) EPC

(43) Date of publication:
**14.06.2023 Bulletin 2023/24**

(21) Application number: **21854128.2**

(22) Date of filing: **04.08.2021**

(51) International Patent Classification (IPC):
***G09F 9/30*** *(2006.01)*

(86) International application number:
**PCT/CN2021/110538**

(87) International publication number:
**WO 2022/028478 (10.02.2022 Gazette 2022/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **05.08.2020 CN 202010779898**

(71) Applicant: **Vivo Mobile Communication Co., Ltd.
Dongguan, Guangdong 523863 (CN)**

(72) Inventor: **DUAN, Junjie
Dongguan, Guangdong 523863 (CN)**

(74) Representative: **Lavoix
Bayerstraße 83
80335 München (DE)**

(54) **DISPLAY MODULE, AND ELECTRONIC DEVICE**

(57) A display module and an electronic device, where the display module comprises a first filter layer (10), a light-emitting layer (20), a second filter layer (30), and a photosensitive element (40), where the light-emitting layer (20) is disposed between the first filter layer (10) and the second filter layer (30), the second filter layer (30) is disposed between the light-emitting layer (20) and the photosensitive element (40); the second filter layer (30) comprises a first filter part (31) and a second filter part (32) disposed adjacent to each other, the first filter layer (10) and the first filter part (31) form an ambient light passing structure, and the first filter layer (10) and the second filter part (32) form an ambient light filter structure; the photosensitive element (40) comprises a first photosensitive part (41) and a second photosensitive part (42), where the first photosensitive part (41) is disposed opposite to the first filter part (31), and the second photosensitive part (42) is disposed opposite to the second filter part (32); under the action of ambient light, a photosensitive amount of the first photosensitive part is greater than a photosensitive amount of the second photosensitive part.

FIG. 1

EP 4 195 185 A1

**Description**

**CROSS-REFERENCE TO RELATED APPLICATIONS**

This application claims priority to Chinese Patent Application No. 202010779898.2 filed in China on August 5, 2020, which is incorporated herein by reference in its entirety.

**TECHNICAL FIELD**

This application belongs to the field of electronic technologies, and specifically, relates to a display module and an electronic device.

**BACKGROUND**

With the popularization of the application of full screens in mobile phone products, the front sensors on mobile phones include cameras, distance sensors, photosensitive sensors, pickups, etc. It is necessary to consider how to design them to ensure that they can continue to function. At present, there are some telescopic camera solutions, under-screen sensing solutions, and micro-slit technology solutions, etc.

In the actual use process, the display module can usually detect the external ambient light, but at the same time, because the light-emitting layer in the display module will also generate light, and the above-mentioned light will interfere with the detection result of the ambient light. It can be seen that the current accuracy of detection results of ambient light is low.

**SUMMARY**

The purpose of the embodiments of this application is to provide a display module and an electronic device, which can solve the current problem of low accuracy of detection results of ambient light.

To resolve the foregoing technical problem, this application is implemented as follows.

An embodiment of this application provides a display module, including: a first filter layer, a light-emitting layer, a second filter layer, and a photosensitive element, where the light-emitting layer is disposed between the first filter layer and the second filter layer, and the second filter layer is disposed between the light-emitting layer and the photosensitive element.

The second filter layer includes a first filter part and a second filter part disposed adjacently, the first filter layer and the first filter part form an ambient light passing structure, the first filter layer and the second filter part form an ambient light filter structure, the photosensitive element includes a first photosensitive part and a second photosensitive part, the first photosensitive part is disposed opposite to the first filter part, the second photosensitive part is disposed opposite to the second filter part, and under the action of ambient light, a photosensitive amount of the first photosensitive part is greater than a photosensitive amount of the second photosensitive part.

In the embodiments of this application, the first filter layer and the first filter part form an ambient light passing structure, the first filter layer and the second filter part form an ambient light filter structure, the first photosensitive part and the first filter part are disposed opposite to each other, and the second light-sensitive part and the second filter part are disposed opposite to each other. In this way, the transmittance of ambient light in the ambient light filter structure is relatively low, and the transmittance of ambient light in the ambient light passing structure is relatively high. Therefore, the error of the value of the ambient light calculated based on the photosensitive amounts of the first photosensitive part and the second photosensitive part is small, thereby improving the accuracy of the detection result of the ambient light.

**BRIEF DESCRIPTION OF DRAWINGS**

FIG 1 is a structural schematic diagram 1 of a display module provided by an embodiment of this application;

FIG 2 is a structural schematic diagram 2 of a display module provided by an embodiment of this application;

FIG. 3 is a structural schematic diagram 3 of a display module provided by an embodiment of this application;

FIG. 4 is a structural schematic diagram 4 of a display module provided by an embodiment of this application;

FIG. 5 is a structural schematic diagram 5 of a display module provided by an embodiment of this application;

FIG. 6 is a structural schematic diagram 6 of a display module provided by an embodiment of this application;

FIG. 7 is a structural schematic diagram 7 of a display module provided by an embodiment of This application;

FIG. 8 is a structural schematic diagram 8 of a display module provided by an embodiment of this application;

FIG. 9 is a structural schematic diagram 9 of a display module provided by an embodiment of this application;

FIG 10 is a structural schematic diagram 10 of a display module provided by an embodiment of this application;

FIG 11 is a structural schematic diagram 11 of a display module provided by an embodiment of this application;

FIG. 12 is a structural schematic diagram 12 of a display module provided by an embodiment of this application; and

FIG. 13 is a circuit structural diagram provided by an embodiment of this application.

## DESCRIPTION OF EMBODIMENTS

The following clearly and completely describes the technical solutions in the embodiments of this application with reference to the accompanying drawings in the embodiments of this application. Apparently, the described embodiments are some but not all of the embodiments of this application. All other embodiments obtained by a person of ordinary skill in the art based on the embodiments of this application without creative efforts shall fall within the protection scope of this application.

The terms "first", "second", and the like in the specification and claims of this application are used to distinguish between similar objects instead of describing a specific order or sequence. It should be understood that data used in this way may be interchangeable in an appropriate case, so that the embodiments of this application can be implemented in a sequence other than those shown or described herein, and objects distinguished by "first" and "second" are generally of a same type, and a quantity of objects is not limited. For example, there may be one or more first targets. In addition, in the specification and the claims, "and/or" represents at least one of connected objects, and a character "/" generally represents an "or" relationship between associated objects.

With reference to the accompanying drawings, the following describes in detail the electronic device in the embodiments of this application based on specific embodiments and application scenarios.

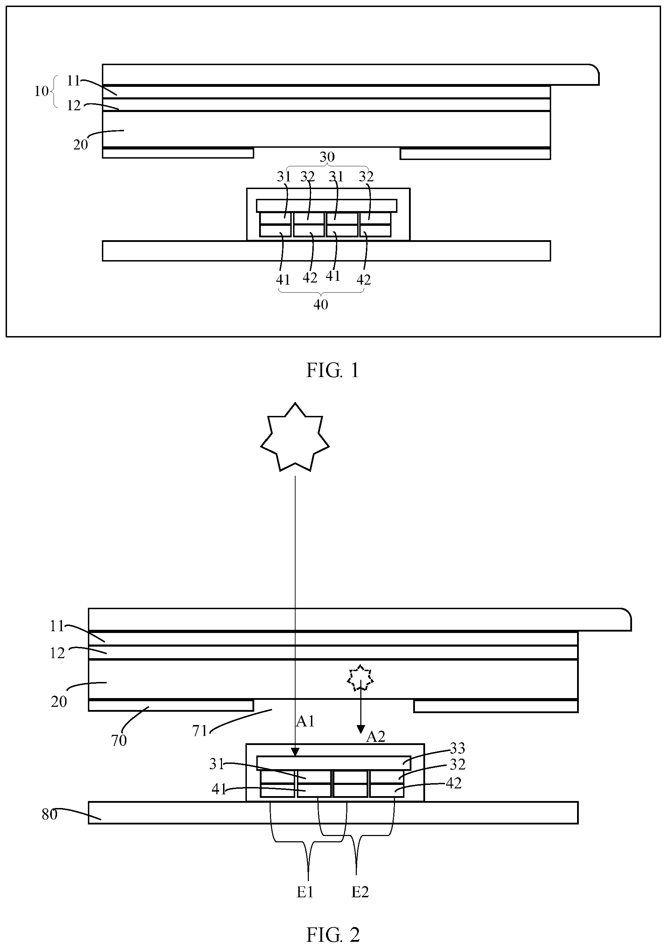

Referring to FIG 1, FIG 1 is a schematic structural diagram of a display module provided by an embodiment of this application. As shown in FIG 1, the display module includes: a first filter layer 10, a light emitting layer 20, a second filter layer 30, and a photosensitive element 40, where the light-emitting layer 20 is disposed between the first filter layer 10 and the second filter layer 30, and the second filter layer 30 is disposed between the light-emitting layer 20 and the photosensitive element 40.

The second filter layer 30 includes a first filter part 31 and a second filter part 32 disposed adjacently, the first filter layer 10 and the first filter part 31 form an ambient light passing structure, the first filter layer 10 and the second filter part 32 form an ambient light filter structure, the photosensitive element 40 includes a first photosensitive part 41 and a second photosensitive part 42, the first photosensitive part 41 is disposed opposite to the first filter part 31, the second photosensitive part 42 is disposed opposite to the second filter part 32, and under the action of ambient light, a photosensitive amount of the first photosensitive part 41 is greater than a photosensitive amount of the second photosensitive part 42.

The transmittance of ambient light in the ambient light passing structure is higher than the transmittance of ambient light in the ambient light filter structure. At the same time, since the first photosensitive part 41 is disposed opposite to the first filter part 31, and the second photosensitive part 42 is disposed opposite to the second filter part 32, the number of ambient light rays received in the first photosensitive part 41 is greater than the number of ambient light rays received in the second photosensitive part 42. At the same time, because only the second filter layer 30 is disposed between the light-emitting layer 20 and the photosensitive element 40, a difference between numbers of light rays of the light-emitting layer 30 received by the first photosensitive part 41 and the second photosensitive part 42 is small. Therefore, the photosensitive amount received by the first photosensitive part 41 is greater than the photosensitive amount received by the second photosensitive part 42.

For example: the transmittance of ambient light in the ambient light passing structure can be 100%, the transmittance in the ambient light filter structure can be lower (such as 20%, 10% or 0), and light emitted by the light-emitting layer 20 does not need to pass through the first filter layer 10. Therefore, the transmittance in the first filter part 31 and the second filter part 32 can be the same (for example: both are 45%), and then the number of light rays of the light-emitting layer 20 illuminated on the first photosensitive part 41 and the second photosensitive part 42 can be the same (or the difference is small and negligible). In this way, the light rays received on the first photosensitive part 41 can include ambient light and light of the light-emitting layer 20, and the light rays received on the second photosensitive part 42 may include ambient light (essentially negligible) and light of the light-emitting layer 20. Then, the difference between the light rays on the first photosensitive part 41 and the second photosensitive part 42 is calculated, and the difference is the detection result of ambient light. When the number of ambient light rays included in the light rays received on the second photosensitive part 42 is less, the error of the detection result of ambient light is smaller, that is, the accuracy of the detection result of ambient light is higher.

It should be noted that all the display modules in the embodiments of this application can be applied to electronic devices.

In order to improve the accuracy of the detection result of ambient light, as an optional implementation manner, the polarization directions of the first filter part 31 is perpendicular to the polarization direction of the second filter part 32, the polarization direction of the first filter part 31 is parallel to the polarization direction of the first filter layer 10, and the polarization direction of the second filter part 32 is perpendicular to the polarization direction of the first filter layer 10.

In this embodiment, the first light emitted by the light-emitting layer is transmitted to the first photosensitive part 41 and the second photosensitive part 42 through the first filter part 31 and the second filter part 32 respectively, the second light in the external environment (the second light can also be referred to as ambient light) is transmitted to the first photosensitive part 41 only through the first filter layer 10, the light-emitting layer 20, and the first filter part 31 in sequence.

The working principles of the embodiments of this application can be referred to the following expressions:

Since the polarization direction of the first filter part 31 is parallel to the polarization direction of the first filter layer 10 and the polarization direction of the second filter part 32 is perpendicular to the polarization direction of the first filter layer 10, the second light in the external environment can be transmitted to the first photosensitive part 41 through the first filter layer 10 and the first filter part 31 in sequence, and the second light can only pass through the first filter layer 10, but cannot pass through the second filter part 32. That is, the second light cannot be transmitted to the second photosensitive part 42. However, since the light-emitting layer 20 is located between the first filter layer 10 and the second filter layer 30, the first light emitted by the light-emitting layer 20 can pass through the first filter part 31 and the second filter part 32 on the second filter layer 30, and is transmitted to the first photosensitive part 41 and the second photosensitive part 42.

That is, the light received by the first photosensitive part 41 includes first light and second light, while the light received by the second photosensitive part 42 only includes the second light. Therefore, the value of the first light can be calculated based on the value of the light received on the first photosensitive part 41 and the value of the light received on the second photosensitive part 42. This can reduce the interference of the light-emitting layer 20 on the accuracy of the detection result, and the accuracy of the detection result of the photosensitive element 40 can be improved.

In addition, a target operation can be performed based on the value of the first light obtained from the above calculation, and the target operation can include at least one of the following: the distance between an obstacle in the external environment and the electronic device can be calculated, or light intensity in the external environment can be detected, etc. It should be noted that the value of the light may refer to an intensity value of the light.

For example: referring to FIG 2, the energy of the external ambient light (that is, the second light) is A1, the energy of the light emitted by the screen (that is, the first light) is A2, the energy received on the first photosensitive part 41 is E1, the energy received by the second photosensitive part 42 is E2, and finally the following equation is obtained:

$$E1 = a * A1 + b * A2;$$

and

$$E2 = c * A2;$$

E1 and E1 are actual measured values of the first photosensitive part 41 and the second photosensitive part 42 in the photosensitive element 40 respectively, a, b, and c are adjustable parameters, and A1 and A2 are values that need to be measured (that is, values to be measured).

a, b, and c can be calculated in the following manner:

Step 1: Control the light-emitting layer 20 to not emit light (that is, the light-emitting layer 20 does not emit the first light), that is, A2=0, to obtain E1_1 and E2_1. Then,

$$E1\_1 = a * A1; \; \text{①}$$

Step 2. Block ambient light (that is, do not let the second light in the external environment illuminate into the electronic device), that is, A1=0, to obtain E1_2 and E2_2. Then,

$$E1\_2 = b * A2; \; \text{②}$$

$$E2\_2 = c * A2; \; \text{③}$$

Step 3. Control the brightness of the light-emitting layer 20 to be halved (that is, the first light is half of the target brightness, and the target brightness can be the rated brightness or the maximum brightness) to obtain E1_3 and E2_3. Then,

$$E1\_3 = a * A1 + b * A2 * 50\%; \; \text{④}$$

$$E2\_3 = c * A2 * 50\%; \; \text{⑤}$$

In this way, in the above equations ①, ②, ③, ④ and ⑤, E1_n and E2_n is a known quantity (where n is a positive integer), and through the five equations, three parameters a, b, and c may be calculated, and the three parameters a, b, and c represent the transmittance of the first light and the second light and are not affected by the values of A1 and A2. Therefore, the three parameters a, b, c are fixed values, so that the values of A1 and A2 can be accurately calculated.

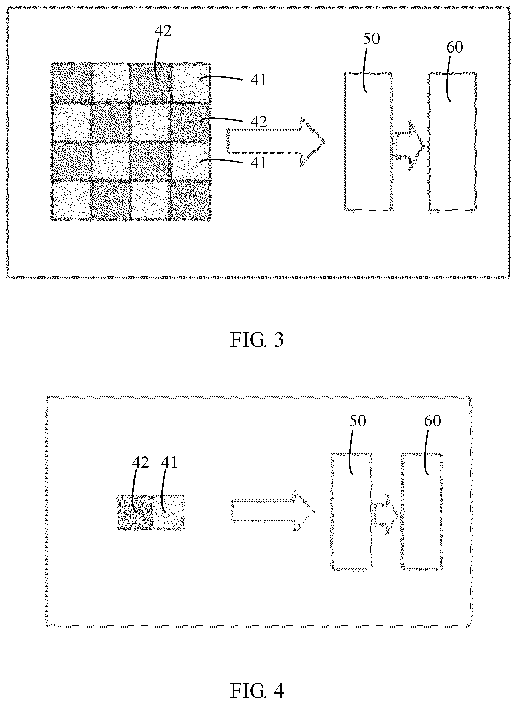

The numbers of the first photosensitive parts 41 and the second photosensitive parts 42 are not limited herein. For example, referring to FIG 4, the numbers of the first photosensitive parts 41 and the second photosensitive parts 42 may both be one. Certainly, in FIG 3 and FIG 5 to FIG 12, the numbers of the first photosensitive parts 41 and the second photosensitive parts 42 may also be at least two. In addition, the number of the first photosensitive parts 41 and the number of the second photosensitive parts 42 may be the same or different.

As an optional implementation manner, the number of the first photosensitive parts 41 is at least two, and at least two first photosensitive parts 41 are connected to a first multiplexer.

As another optional implementation manner, the number of the second photosensitive parts 42 is at least two, and at least two second photosensitive parts 42 are connected to a second multiplexer.

In this way, the first multiplexer can combine the light detected on the at least two first photosensitive parts 41, and the second multiplexer can combine the light detected on the at least two second photosensitive parts 42, so that the detection result of light is more accurate.

In addition, as an optional implementation manner, referring to FIG 3 to FIG 12, the first multiplexer and the second multiplexer may be the same multiplexer, and the multiplexer 50 may be connected to an analog-to-digital converter (ADC) 60. In another optional implementation, the first multiplexer and the second multiplexer can be two different multiplexers, and the first multiplexer and the second multiplexer can be respectively connected with the analog-to-digital converter 60, so that the light detected on the at least two first photosensitive parts 41 can be collected in the analog-to-digital converter 60 and a corresponding value E1 is generated, and the light detected on the at least two second photosensitive parts 42 can be collected in the analog-to-digital converter 60 and a corresponding value E2 is generated.

It should be noted that the first multiplexer and the second multiplexer may be set at the same time, or only one of them may be set, which is not specifically limited herein.

In addition, referring to FIG 3 to FIG 12, arrows in the figures may indicate transmission directions of signals.

As an optional implementation manner, the at least two first photosensitive parts 41 and at least two second photosensitive parts 42 may be disposed linearly.

As another optional embodiment, when the number of the first photosensitive parts 41 is at least two and the number of the second photosensitive parts 42 is at least two, the at least two first photosensitive parts 41 and the at least two second photosensitive parts 42 are distributed in an array. In this way, the distribution of the first photosensitive parts 41 and the second photosensitive parts 42 can be made more uniform, and the light receiving effect is better.

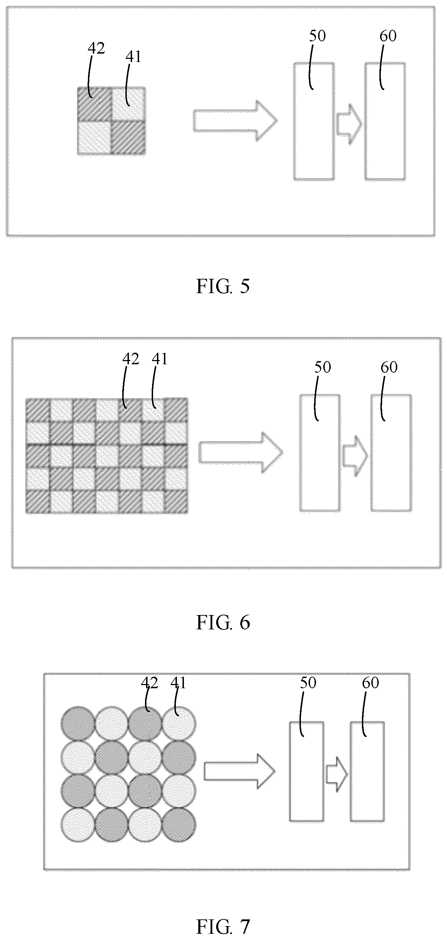

The specific method of the array distribution is not limited herein. For example: referring to FIG 3, a 4*4 array can be used; referring to FIG 4, a 1*2 array can be used; referring to FIG 5, a 2*2 array method can be used; or referring to FIG 6, a 5*7 array can be used.

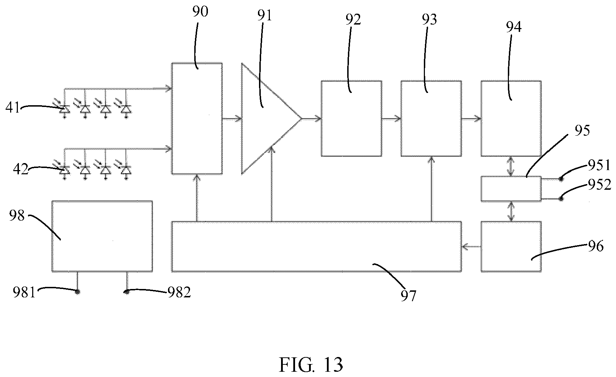

In addition, referring to FIG 13, FIG 13 is a circuit structure diagram when the display module in this embodiment is applied to an electronic device. The display module specifically includes four first photosensitive parts 41 and four second photosensitive parts 42, and the four first photosensitive parts 41 and the four second photosensitive parts 42 are distributed in an array. In addition, the circuit also includes: a multiplexer (Multiplexer, MUX) 90, a weak signal detection circuit (PGA) 91, an analog-to-digital converter (ADC) 92, a digital filter (Digital filtering) 93, a memory (Random Access Memory, RAM) 94, an internal integrated circuit (I$^2$C) 95, an electrically erasable programmable read-only memory (Electrically Erasable Programmable Read-Only Memory, EEPROM) 96, a state machine (State Machine) 97, a regulator POR oscillator (Regulator POR Oscillator) 98, and other components. The internal integrated circuit (I$^2$C) 95 includes a data line (SDA) 952 and a control line (SCL) 951, and the regulator POR oscillator (Regulator POR Oscillator) 98 and other components include a power supply terminal (VDD) 981 and a ground terminal (GND) 982. The connection relationship of the above components can be shown in FIG 13. Arrows in FIG 13 may indicate the flow of currents.

Optionally, the second filter layer 30 includes a plurality of filter groups, each filter group includes the first filter part 31 and the second filter part 32, and at least two filter groups correspond to different filter bands.

Each filter group may include a plurality of first filter parts 31 and a plurality of second filter parts 32, and the first filter parts 31 and second filter parts 32 included in each filter group can also be distributed in an array or linearly.

The filter bands corresponding to any two filter groups in the plurality of filter groups can be different, or certainly, the filter bands corresponding to some filter groups in the plurality of filter groups are the same and the filter bands corresponding to some filter groups are different.

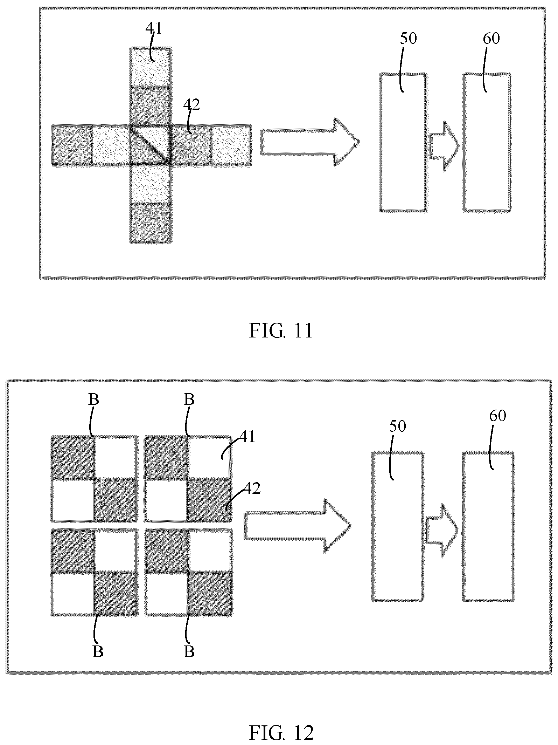

For example: referring to FIG 12, FIG 12 includes four filter groups, each filter group is represented by B, the filter band corresponding to the filter group in the upper left corner can be red (which can be understood as that only red light is allowed to pass through), the filter band corresponding to the filter group in the upper right corner can be green, the filter band corresponding to the filter group in the lower left corner can be blue, and the filter band corresponding to the filter group in the lower right corner can be infrared light.

It should be noted that the filter bands corresponding to the filter groups can be designed and configured as required.

In this way, since a plurality of filter groups are included and at least two filter groups correspond to different filter bands, the diversity and flexibility of filter methods are increased.

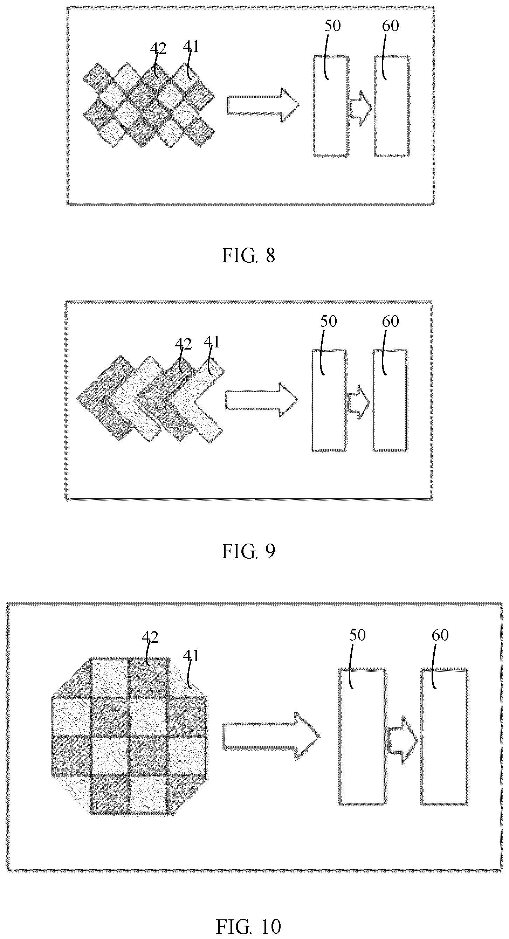

Shape of the first photosensitive part 41 and shape of the second photosensitive part 42 can be the same. For example: referring to FIG 6 to FIG 9, both the first photosensitive part 41 and the second photosensitive part 42 can be rectangular, circular, rhombic or irregular polygons, and their dimensions can be the same. Of course, the shapes of the first photosensitive parts 41 and the shapes of the second photosensitive parts 42 can be partially the same and partially different. For example, refer to FIG 10 and FIG 11, some first photosensitive parts 41 can be rectangular and the other first photosensitive parts 41 can be triangular; some second photosensitive parts 42 may be rectangular and the other second photosensitive parts 42 may be triangular. In this way, the second filter layer 30 may be in the shape of a circle or a cross.

As an optional implementation manner, the shapes of the first filter part 31 and the first photosensitive part 41 are adapted to each other; as another optional implementation manner, and the shapes of the second filter part 32 and the second photosensitive part 42 are adapted to each other. It should be noted that the above two optional implementation manners may be implemented simultaneously, or only one of them may be implemented.

In this way, since the shapes of the first filter part 31 and the first photosensitive part 41 are adapted to each other and the shapes of the second filter part 32 and the second photosensitive part 42 are adapted to each other, this reduces occurrences that some positions cannot be filtered due to mismatched shapes, so that the detection effect of light is better.

As an optional implementation manner, at least one of the first filter layer 10 and the second filter layer 30 is a filter plate or a filter film, or at least one of the first filter layer 10 and the second filter layer 30 is a polarizer.

As another optional implementation manner, the first filter layer 10 includes a first linear polarizer and a first quarter wave plate, and the first quarter wave plate is located between the first linear polarizer and the light-emitting layer 20.

As another optional implementation manner, the second filter layer 30 further includes a second quarter wave plate 33, the second quarter wave plate 33 includes a first surface and a second surface disposed opposite to each other, the first surface is disposed toward the light-emitting layer 20, and the second surface is disposed toward the first filter part 31 and the second filter part 32.

In the embodiments of this application, the first filter layer 10 includes the first linear polarizer 11 and the first quarter wave plate 12, the second filter layer 30 also includes the second quarter wave plate 33, and both the first filter part 31 and the second filter part 32 can be called linear polarizers. In this way, on the basis of filtering the light, the usage costs can be reduced and the assembly process can be simplified.

The first quarter wave plate 12 and the second quarter wave plate 33 can be referred to as a 1/4 wave plate or a $1/4\lambda$ wave plate respectively. The polarization direction of the first filter layer 10 can refer to the polarization direction of the first linear polarizer 11, the polarization direction of the second filter layer 30 can refer to the polarization directions of the first filter part 31 and the second filter part 32, and the polarization directions of the first filter part 31 and the second filter part 32 may refer to certain directions along the horizontal plane where the first filter layer 10 is located, for example, may be a horizontal direction in the horizontal plane or a direction perpendicular to the horizontal direction.

As an optional implementation mode, the first linear polarizer 11 and the first quarter wave plate 12 can be laminated, and the first filter part 31, the second filter part 32, and the second quarter wave plate 33 can be laminated. As another optional embodiment, the first linear polarizer 11 and the first quarter wave plate 12 can be disposed at intervals, and the first filter part 31, the second filter part 32, and the second quarter wave plate 33 can be disposed at intervals. For example: the first linear polarizer 11 and the first quarter wave plate 12 can be disposed at intervals through an adhesive layer, or there can be a gap between the first linear polarizer 11 and the first quarter wave plate 12. Correspondingly, for the positional relationship between the first filter part 31, the second filter part 32, and the second quarter wave plate 33, refer to the above descriptions of the first linear polarizer 11 and the first quarter wave plate 12. Details are not repeated herein.

The specific type of the light-emitting layer 20 is not limited herein, and as an optional implementation manner, the light-emitting layer 20 is an organic light-emitting diode (Organic Light-Emitting Diode, OLED) light-emitting layer. In this way, the light emitting effect of the light-emitting layer 20 can be improved.

It should be noted that when the light-emitting layer 20 is an OLED light-emitting layer, the light-emitting layer 20 and the first filter layer 10 may be combined to form a part of the display module, that is, the light-emitting layer 20 and the first filter layer 10 may form two parts of an OLED display module.

As an optional implementation manner, referring to FIG 1 and FIG 2, a light shielding layer 70 is further disposed between the light-emitting layer 20 and the second filter layer 30. A light-transmitting hole 71 is opened at a position of the light shielding layer 70 opposite to the second filter layer 30. In this way, since the position that is of the light shielding layer 70 and that is not provided with the light-transmitting hole 71 can shield the light, thereby reducing the amount of light transmitted to the photosensitive element 40 and further reducing the impact of other light on the accuracy of the detection result of the photosensitive element 40, that is, the accuracy of the detection result of the photosensitive element 40 is further improved.

The specific material of the light shielding layer 70 is not limited herein. For example, the light shielding layer 70 can be a light shielding foam layer, which reduces the usage costs and can also have the buffering effect between the light-emitting layer 20 and the second filter layer 30. In addition, the light shielding layer 70 may also be a light shielding rubber layer or a light shielding plating layer or the like.

Optionally, the display module can be applied to an electronic device. The electronic device further includes a casing, and the casing is provided with an accommodating groove. The display screen, the first filter layer 10, the light-emitting layer 20, the second filter layer 30, and the photosensitive element 40 are all located in the accommodating groove, and the photosensitive element 40 is located between the light-emitting layer 20 and the bottom of the accommodating groove.

In the embodiments of this application, since the photosensitive element 40 is located between the light-emitting layer 20 and the bottom of the accommodating groove, there is no need to open a light-transmitting hole of the photosensitive element 40 on the light-emitting layer 20, thereby increasing the screen ratio. It should be noted that the light-emitting layer 20 and the first filter layer 10 can be combined to form a display module. When the light-emitting layer 20 is an OLED light-emitting layer, the display module is an OLED display module.

It should be noted that, as an optional implementation manner, the photosensitive element 40 includes at least one of a photosensitive sensor, an infrared sensor, a fingerprint sensor and a camera module. In this way, the diversity of the photosensitive elements 40 is increased, and at the same time, the intelligence level of the electronic device is also increased.

When the photosensitive element 40 includes a photosensitive sensor and the value of the second light in the external environment is calculated, the controller of the electronic device can control other components in the electronic device to perform the target operation, and the target operation can include at least one of the following: adjusting the display brightness of the display, adjusting the contrast of the display, and adjusting the backlight color of the display.

When the photosensitive element 40 includes an infrared sensor and the value of the second light in the external environment is calculated, the second light can be reflected infrared light that returns after light is emitted by the light-emitting layer 20 and projected out of the display screen and encounters an obstacle. In this way, when the value of the second light is calculated, the distance between the obstacle and the electronic device can be determined according to the value, and the state of the display screen can be determined as an on screen state or an off screen state according to the distance.

When the photosensitive element 40 includes a fingerprint sensor or a camera module, an image can be acquired through the second photosensitive part 32. For example: since only the first light is transmitted to the second photosensitive part 32, the image can be acquired through the second photosensitive part 32, thereby reducing the influence of the second light in the external environment on the imaging quality. Both the first light and the second light can be transmitted to the first photosensitive part 31, so that an image can be acquired through the first photosensitive part 31, thereby enhancing the display brightness of the acquired image.

As an optional implementation manner, referring to FIG 1 and FIG 2, the electronic device further includes a printed circuit board 80, and the photosensitive element 40 is disposed on the printed circuit board 80. In this way, the photosensitive element 40 can be powered by the printed circuit board 80, and at the same time, the printed circuit board 80 can also play a supporting role for the photosensitive element 40.

The embodiments of this application also provide an electronic device, including the display module in the above embodiments. Since the electronic device provided by the embodiments of this application includes the display module in the mentioned embodiments, it has the same beneficial technical effects as the above embodiments. For the structure of the display module, refer to the corresponding descriptions in the above embodiments, and details are not repeated herein.

The embodiments of this application are described above with reference to the accompanying drawings, but this application is not limited to the foregoing specific implementation manners. The foregoing specific implementation manners are merely schematic instead of restrictive. Under enlightenment of this application, a person of ordinary skills in the art may make many forms without departing from aims and the protection scope of claims of this application, all of which fall within the protection scope of this application.

**Claims**

1. A display module, comprising: a first filter layer, a light-emitting layer, a second filter layer, and a photosensitive element, wherein the light-emitting layer is disposed between the first filter layer and the second filter layer, and the second filter layer is disposed between the light-emitting layer and the photosensitive element; and

   the second filter layer comprises a first filter part and a second filter part disposed adjacently, the first filter layer and the first filter part form an ambient light passing structure, the first filter layer and the second filter part form an ambient light filter structure, the photosensitive element comprises a first photosensitive part and a second photosensitive part, the first photosensitive part is disposed opposite to the first filter part, the second photosensitive part is disposed opposite to the second filter part, and under the action of ambient light, a photosensitive amount of the first photosensitive part is greater than a photosensitive amount of the second photosensitive part.

2. The display module according to claim 1, wherein a polarization direction of the first filter part is perpendicular to a polarization direction of the second filter part, the polarization direction of the first filter part is parallel to the polarization direction of the first filter layer, and the polarization direction of the second filter part is perpendicular to the polarization direction of the first filter layer.

3. The display module according to claim 1, wherein the number of the first photosensitive parts is at least two, and at least two first photosensitive parts are connected to the first multiplexer; and/or the number of the second photosensitive parts is at least two, and at least two second photosensitive parts are connected to a second multiplexer.

4. The display module according to claim 3, wherein when the number of the first photosensitive parts is at least two and the number of the second photosensitive parts is at least two, the at least two first photosensitive parts and the at least two second photosensitive parts are disposed in an array.

5. The display module according to claim 1, wherein the second filter layer comprises a plurality of filter groups, each filter group comprises the first filter part and the second filter part, and at least two filter groups correspond to different filter bands.

6. The display module according to claim 1, wherein shapes of the first filter part and the first photosensitive part are adapted to each other, and/or shapes of the second filter part and the second photosensitive part are adapted to each other.

7. The display module according to claim 1, wherein the first filter layer comprises a first linear polarizer and a first quarter wave plate, and the first quarter wave plate is located between the first linear polarizer and the light-emitting layer.

8. The display module according to claim 1, wherein the second filter layer further comprises a second quarter wave plate, the second quarter wave plate comprises a first surface and a second surface disposed opposite to each other, the first surface is disposed toward the light-emitting layer, and the second surface is disposed toward the first filter part and the second filter part.

9. The display module according to claim 1, wherein the light-emitting layer is an organic light-emitting diode (OLED) light-emitting layer.

10. An electronic device, comprising the display module according to any one of claims 1 to 9.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

## INTERNATIONAL SEARCH REPORT

| International application No. |
| --- |
| **PCT/CN2021/110538** |

### A. CLASSIFICATION OF SUBJECT MATTER

G09F 9/30(2006.01)i

According to International Patent Classification (IPC) or to both national classification and IPC

### B. FIELDS SEARCHED

Minimum documentation searched (classification system followed by classification symbols)

G09F

Documentation searched other than minimum documentation to the extent that such documents are included in the fields searched

Electronic data base consulted during the international search (name of data base and, where practicable, search terms used)

CNKI, CNPAT, WPI, EPODOC: 显示, 滤光, 感光, 环境光, 传感器, 第二, 差, display, filter, photosensor, sensor, ambient, light, second, difference

### C. DOCUMENTS CONSIDERED TO BE RELEVANT

| Category* | Citation of document, with indication, where appropriate, of the relevant passages | Relevant to claim No. |
| --- | --- | --- |
| PX | CN 111933027 A (VIVO COMMUNICATION TECHNOLOGY CO., LTD.) 13 November 2020 (2020-11-13)<br>    description, paragraphs [0025]-[0087], and figures 1-13 | 1-10 |
| X | CN 107909922 A (VIVO COMMUNICATION TECHNOLOGY CO., LTD.) 13 April 2018 (2018-04-13)<br>    description, paragraphs [0008]-[0045], and figures 1-2 | 1-10 |
| A | CN 108983470 A (OPPO GUANGDONG MOBILE COMMUNICATIONS CO., LTD.) 11 December 2018 (2018-12-11)<br>    entire document | 1-10 |
| A | CN 107818753 A (GUANGDONG OPPO MOBILE TELECOMMUNICATIONS CORP., LTD.) 20 March 2018 (2018-03-20)<br>    entire document | 1-10 |
| A | CN 106461991 A (SHARP CORPORATION) 22 February 2017 (2017-02-22)<br>    entire document | 1-10 |
| A | CN 107767835 A (GUANGDONG OPPO MOBILE TELECOMMUNICATIONS CORP., LTD.) 06 March 2018 (2018-03-06)<br>    entire document | 1-10 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **09 October 2021** | **03 November 2021** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2021/110538**

**C.    DOCUMENTS CONSIDERED TO BE RELEVANT**

| Category* | Citation of document, with indication, where appropriate, of the relevant passages | Relevant to claim No. |
|---|---|---|
| A | US 2007034784 A1 (SILICON TOUCH TECHNOLOGY INC.) 15 February 2007 (2007-02-15)<br>    entire document | 1-10 |

Form PCT/ISA/210 (second sheet) (January 2015)

International application No.

**PCT/CN2021/110538**

| Patent document cited in search report | | | Publication date (day/month/year) | Patent family member(s) | | | Publication date (day/month/year) |
|---|---|---|---|---|---|---|---|
| CN | 111933027 | A | 13 November 2020 | None | | | |
| CN | 107909922 | A | 13 April 2018 | CN | 107909922 | B | 15 October 2019 |
| CN | 108983470 | A | 11 December 2018 | None | | | |
| CN | 107818753 | A | 20 March 2018 | None | | | |
| CN | 106461991 | A | 22 February 2017 | US | 2017169749 | A1 | 15 June 2017 |
| | | | | WO | 2015174276 | A1 | 19 November 2015 |
| | | | | US | 9984612 | B2 | 29 May 2018 |
| CN | 107767835 | A | 06 March 2018 | CN | 107767835 | B | 10 April 2020 |
| US | 2007034784 | A1 | 15 February 2007 | TW | 200707768 | A | 16 February 2007 |
| | | | | JP | 2007053338 | A | 01 March 2007 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010779898